# EUROPEAN PATENT APPLICATION

(11) **EP 1 302 569 A2**
(43) Date of publication of application: **16.04.2003**
(21) Application number: 02257019.6
(22) Date of filing: 09.10.2002
(51) Int. Cl.: C25F 5/00

(54) **Stripping solution**

(30) Priority: 11.10.2001 US 328221 P; 12.10.2001 US 328772 P
(71) Applicant: Shipley Co. L.L.C., Marlborough, MA 01752 (US)
(72) Inventor: Boguslavsky, Irini, Northport, New York 11768 (US); Chirafisi, Angelo, Howard Beach, New York 11414 (US); Toben, Michael P., Smithtown, New York 11787 (US)
(74) Representative: Kent, Venetia Katherine

(57) **Abstract**

Disclosed are compositions suitable for the electrolytic stripping of tin and tin-alloys from a substrate as well as methods of stripping such tin and tin-alloys. The compositions are particularly suitable for the electrolytic stripping of lead-free tin alloys, and more particularly for stripping tin and tin-alloys from stainless steel substrates.

## Description

### Background of the Invention

The present invention relates generally to the field of tin and tin-alloy plating. In particular, the present invention relates to the field of removing tin and tin-alloys from a substrate.

Tin and tin-alloys have been used as solderable finishes in electronic devices for a number of years. In particular, in the manufacture of printed wiring boards it is commonplace to deposit a layer of tin or tin-alloy (solder) on all or selected conductive copper surfaces of the board defining traces, through-holes, surrounding pad areas and the like, to serve, for example, as an etch resist in the subsequent etching away of other copper surfaces of the board. In many cases, it is thereafter necessary to strip the tin or tin-alloy from all or selected surfaces coated therewith. For example, it is often necessary to strip the tin or tin-alloy from copper surfaces at selected board areas, such as contact fingers, so that the surfaces can be plated with nickel and/or gold, or it may be necessary to strip the tin or tin-alloy from copper surfaces so that a solder mask can be applied over a bare copper surface ("SMOBC" process). Other times it is necessary to strip tin or tin-alloy from a rejected piece as part of a process for recovering and reusing underlying copper material.

The manufacture of packaging for electronic devices also utilizes tin or tin-alloys as solderable finishes. For example, in the manufacture of lead frames, a strip containing the lead frames is attached to a continuous stainless steel belt by way of clips. The belt transports the frames through each of a variety of manufacturing processes, including tin or tin alloy plating. During such plating, the lead frames, the stainless steel belt and the clips, which are typically stainless steel, are all exposed to the tin or tin-alloy plating bath. During such plating processes, the belt functions as the cathode. As a result, tin or tin-alloy is deposited on the lead frames as well as on the stainless steel belt and clips. As the belt is continuous, it is repeatedly exposed to such tin or tin-alloy plating resulting in the buildup of tin or tin-alloy deposits on the belt. Such tin or tin-alloy deposits on the belt are not desirable. Thus, following tin or tin-alloy plating of the lead frames and removal of the lead frames from the belt, the tin or tin-alloy deposits on the belt and clips are removed by contacting the belt and clips with a tin or tin-alloy stripping bath prior to new lead frames to be processed being affixed to the belt. Such stripping process is typically electrolytic and must proceed fairly quickly in order for the belt to reach the beginning of the process to pick up fresh lead frames in a timely fashion.

Tin-lead is the tin alloy of choice in the manufacture of electronic devices as well as the plating of electronic packaging. A wide variety of tin and tin-lead strippers is known. For example, U.S. Patent No. 3,677,949 (Brindisi et al.) discloses a tin and tin-lead stripper including a nitro-substituted aromatic compound, an inorganic acid selected from fluorine-containing inorganic acids and sulfamic acid, thiourea, and optionally containing an organic acid accelerator. Suitable organic acid accelerators include acetic acid, propionic acid and formic acid. Organic sulfonic acids are not disclosed in this patent. Electrolytic tin stripping is not disclosed in this patent.

Tomaiuolo et al. in U.S. Patent No. 4,4389,338 disclose a tin and tin-lead stripper including a nitro-substituted aromatic compound having an SO₃H or CO₂H group, an alkylsulfonic acid having 1 to 4 carbon atoms, and thiourea or a thiourea derivative. No other acids are disclosed in this patent, nor is electrolytic tin stripping disclosed.

U.S. Patent No. 4,374,744 (Kawanabe et al.) discloses a tin and tin-lead stripper including an inorganic acid and/or organic acid, an oxidizing agent and a nitrogen-containing heterocyclic compound free of sulfur. The only organic acids disclosed are carboxylic acids. Electrolytic tin stripping is not disclosed in this patent.

U.S. Patent No. 5,035,749 (Haruta et al.) discloses a tin and tin-lead stripper including a nitro-substituted aromatic compound, at least one inorganic or organic acid selected from nitric acid, sulfuric acid, borofluoric acid, hydrofluoric acid, sulfamic acid, methanesulfonic acid, glycolic acid, lactic acid and acetic acid, and at least one compound that liberates a halogen atom or halogen-containing complex in acidic solution. Such halogen containing compositions may pose a problem during electrolytic stripping.

A variety of nitric acid containing tin and tin-lead strippers are also known. See, for example, U.S. Patent Nos. 4,397,753 (Czaja) and 5,989,449 (Campbell) as well as U.S. Patent Application No. 2001/0007317 (Letize et al.). Electrolytic tin stripping is not disclosed in these patents.

However, due to environmental concerns, industry is moving to lead-free tin-alloys. Suitable lead-free tin-alloys include tin-silver, tin-bismuth, tin-copper, tin-silver-copper, tin-antimony, and the like. Such lead-free tin alloys are more noble than tin-lead alloys and are, therefore, more difficult to strip than tin-lead alloys. Conventional tin and tin-lead alloy strippers, such as those described above, do not adequately remove such lead-free tin-alloys under standard conditions. Thus, harsher stripping conditions must be employed. For example, to completely strip such lead-free tin-alloys from a stainless steel belt used in lead frame manufacture, higher stripping bath temperatures and longer stripping bath residence times must be used. Such increased residence times also increase the cycle time of the carrier belt through the manufacturing process, thus increasing overall manufacturing time. The increased temperature and residence times also increase the corrosion of the stainless steel belt, thereby reducing its useful life.

There is thus a need for tin and tin-alloy strippers that remove such deposits, particularly lead-free tin-alloy deposits, quickly without significant corrosion of the substrate.

### Summary of the Invention

It has been surprisingly found that tin and lead-free tin-alloys can be quickly and easily removed from a stainless steel substrate without significantly corroding the stainless steel substrate.

In one aspect, the present invention provides a composition suitable for stripping of tin and tin-alloys from a substrate including: a) one or more organic sulfonic acids; b) one or more nitro-substituted organic compounds; and c) at least one of sulfuric acid or a non-ionic surfactant having a cloud point of 50 to 80° C.

In another aspect, the present invention provides a method for electrolytic stripping of tin and tin-alloys from a substrate including the steps of: a) contacting the substrate containing tin or tin-alloy with the composition described above; and b) applying sufficient anodic potential to the substrate to at least partially remove the tin or tin-alloy.

In yet another aspect, the present invention provides a process for the manufacture of electronic devices including a step of stripping tin or tin-alloys from an electronic device substrate including the steps of: a) contacting the substrate containing tin or tin-alloy with the composition described above; and b) a applying sufficient anodic potential to the substrate to at least partially remove the tin or tin-alloy.

In still another aspect, the present invention provides a method for removing tin or tin-alloy from metal conveying equipment used in the manufacture of electronic devices including the steps of: a) contacting the metal conveying equipment containing tin or tin-alloy with the composition described above; and b) a applying sufficient anodic potential to the metal conveying equipment to at least partially remove the tin or tin-alloy.

In a further aspect, the present invention also provides an apparatus for manufacturing electronic devices including a tin or tin-alloy stripping apparatus comprising a tank containing the composition described above, a cathode and a means for applying an anodic potential to a substrate containing tin or tin-alloy.

In a still further aspect, the present invention provides a method of stripping of tin and tin-alloys from a substrate including the step of contacting a substrate containing a tin or tin-alloy deposit with a composition including a) one or more organic sulfonic acids; b) one or more nitro-substituted organic compounds; and c) at least one of sulfuric acid or a non-ionic surfactant having a cloud point of 50 to 80° C; for a period of time sufficient to at least partially remove the tin or tin-alloy from the substrate.

### Detailed Description of the Invention

As used throughout this specification, the following abbreviations shall have the following meanings, unless the context clearly indicates otherwise: ° C = degrees Centigrade; ° F = degrees Fahrenheit; g = gram; L = liter; mL = milliliter; ppm = parts per million; µin/min = microinches per minute; V = volts, SS316 = 316 stainless steel and SS302 = 302 stainless steel. The terms "depositing" and "plating" are used interchangeably throughout this specification. "Stripping" and "removing" are used interchangeably throughout this specification and refer to the removal of at least a portion of the tin or tin-alloy deposit. "Halide" refers to fluoride, chloride, bromide and iodide. Likewise, "halo" refers to fluoro, chloro, bromo and iodo. "Alkyl" refers to linear, branched and cyclic alkyl. Unless other wise indicated, aromatic compounds having two or more substituents include ortho-, meta- and para-substitution. All percentages are by weight, unless otherwise noted. All numerical ranges are inclusive and combinable in any order, except where it is obvious that such numerical ranges are constrained to add up to 100%.

The present invention provides a composition suitable for stripping of tin and tin-alloys from a substrate including: a) one or more organic sulfonic acids; b) one or more nitro-substituted organic compounds; and c) at least one of sulfuric acid or a non-ionic surfactant having a cloud point of 50 to 80° C. Preferably, the present compositions are substantially free of nitric acid and nitrate ions, such as ferric nitrate, and more preferably free of added nitric acid and nitrate ion. By "substantially free" it is meant that the composition contains less than or equal to 0.05% by weight of each of added nitric acid or nitrate ions. The present compositions are particularly suitable for the electrolytic stripping of tin and tin-alloy deposits from a substrate. By "substituted" it is meant that one or more of the hydrogens from the alkyl chain or aromatic ring are replaced by one or more substituents groups. Suitable substituents groups include, but are not limited to, halo, (C₁-C₆)alkoxy, and the like.

Any organic sulfonic acid that is compatible with the stripping composition and functions to strip tin or tin-alloy may be used in the present invention. Suitable organic sulfonic acids include alkanesulfonic acids and arylsulfonic acids. Suitable alkane sulfonic acids include, but are not limited to, (C₁-C₆)alkanesulfonic acids such as methanesulfonic acid, ethanesulfonic acid, propanesulfonic acid and the like. Suitable arylsulfonic acids include, but are not limited to, phenylsulfonic acid, tolylsulfonic acid, and the like. Such organic sulfonic acids may be further substituted, for example, with halogen atoms. Exemplary such substituted organic acids include, but are not limited to, halobenzenesulfonic acids.

The organic sulfonic acids are typically used in the present compositions in a wide range of amounts, such as from 10 to 500 mL/L. Preferably, the organic sulfonic acids are used in an amount from 100 to 450 mL/L and more preferably from 250 to 450 mL/L. A particularly suitable amount of organic sulfonic acid is from 300 to 400 mL/L. Suitable organic sulfonic acids are generally commercially available from a wide variety of suppliers and may be used without further purification. When methanesulfonic acid is used, it is typically available as a 70% solution and may be used as is.

A wide variety of nitro-substituted organic compounds may be used in the present invention. Such nitro-substituted organic compounds are preferably nitro-substituted aromatic compounds. It is further preferred that such nitro-substituted aromatic compounds also contain one or more water-solubility enhancing substituents such as -SO₃H and -CO₂H. Such water-solubility enhancing substituents are even more preferably attached to the aromatic ring. It will be appreciated by those skilled in the art that such nitro-substituted organic compounds may contain one or more nitro-substituents. Suitable nitro-substituted organic compounds include, but are not limited to, nitrobenzenesulfonic acid, alkali and alkaline earth salts of nitrobenzenesulfonic acid, nitrobenzenecarboxylic acid, alkali and alkaline earth salts of nitrobenzenecarboxylic acid, nitrohalobenzenes, nitroanilines, nitrophenols, and the like. Nitrobenzenesulfonic acid is preferred.

The nitro-substituted organic compounds are typically used in the present compositions in a wide range of amounts, such as from 5 to 50 g/L. Preferably, the nitro-substituted organic compounds are used in an amount from 10 to 45 g/L and more preferably from 20 to 40 g/L. A particularly suitable amount of nitro-substituted organic compound is from 20 to 35 g/L. When sulfuric acid is not present in the compositions, it is preferred that ≥ 5 g/L of the nitro-substituted organic compound is used, preferably ≥ 8 g/L, more preferably ≥ 10 g/L, and still more preferably ≥ 15, 20 or 25 g/L. Suitable nitro-substituted organic compounds are generally commercially available from a wide variety of suppliers and may be used without further purification.

The present compositions contain at least one of sulfuric acid or a non-ionic surfactant having a cloud point of 50° to 80° C. When sulfuric acid is used, it is typically used in an amount of at least 1 mL/L. Preferably, the sulfuric acid is present in an amount from 1 to 50 mL/L, and more preferably from 1 to 25 mL/L. A particularly suitable amount of sulfuric acid is from 1 to 10 mL/L, and more particularly from 2 to 10 mL/L, and even more particularly from 2.5 to 8 mL/L. The above amounts of sulfuric acid are based on a 98% solution of sulfuric acid, which has a density of about 1.84 g/ml. Sulfuric acid is commercially available from a number of suppliers and may be used without further purification.

The non-ionic surfactants of the present invention have a cloud point in the range of 50 to 80° C. Mixtures of surfactants having the desired cloud point may also be used in this composition. Suitable surfactants include, but are not limited to poly(alkylene oxide) polymers such as poly(ethylene oxide) polymers, poly(propylene oxide) polymers and poly(ethylene oxide/propylene oxide) polymers. Such polymers may contain two terminal hydroxyl groups, i.e. polyalkylene glycols, or one of the terminal hydroxyls may be capped with an alkyl group having 7 carbons or less or an aromatic group having 20 carbons or less. Such surfactants are disclosed in U.S. Patent No. 4,880,507 (Toben et al.).

Capped poly(alkylene oxide) polymers are typically prepared by condensing a (C₁-C₇)aliphatic or (C₆-C₂₀)aromatic alcohol with a sufficient amount of ethylene oxide, propylene oxide or ethylene oxide/propylene oxide mixture to provide the desired cloud point properties. Exemplary alcohols include, but are not limited to, methanol, n-butanol, phenol, toluol, xylylol, vinylphenol, octylphenol, nonylphenol, β-naphthol, bisphenol A, styrenated phenol, and the like. Particularly suitable surfactants include, but are not limited to, butanol condensed with 4 moles of ethylene oxide, butanol condensed with 10 moles of ethylene oxide, butanol condensed with 15 moles of ethylene oxide, butanol condensed with 16 moles of ethylene oxide and 12 moles of propylene oxide, butanol condensed with 8 moles of ethylene oxide and 6 moles of propylene oxide, phenol condensed with 8 moles of ethylene oxide, phenol condensed with 12 moles of ethylene oxide and 3 moles of propylene oxide, β-naphthol condensed with 13 moles of ethylene oxide, styrenated phenol condensed with 5 moles of ethylene oxide, bisphenol A condensed with 8 moles of ethylene oxide, bisphenol A condensed with 10 moles of ethylene oxide, and bisphenol A condensed with 30 moles of ethylene oxide.

Typically, when the non-ionic surfactants are used, they are used in amounts of from 0.05 to 2 g/L. Preferably, the surfactants are used from 0.05 to 1.5 g/L, and more preferably from 0.1 to 1 g/L. Such surfactants are generally commercially available from a variety of suppliers, such as BASF, Ludwigshafen, Germany.

Particularly suitable compositions of the present invention include sulfuric acid. In one embodiment, the present compositions include: a) one or more organic sulfonic acids; b) one or more nitro-substituted organic compounds; and c) sulfuric acid. In an alternate embodiment, the present compositions include a) one or more organic sulfonic acids; b) one or more nitro-substituted organic compounds; and c) a non-ionic surfactant having a cloud point of 50° to 80° C. It is preferred that both sulfuric acid and a non-ionic surfactant having a cloud point of 50° to 80° C are used. In a preferred embodiment, the present compositions include a) one or more organic sulfonic acids; b) one or more nitro-substituted organic compounds; c) sulfuric acid; and d) a non-ionic surfactant having a cloud point of 50° to 80° C. Such compositions are preferably free of added nitric acid and nitrate ion.

The present compositions may further include one or more additional components, such as additional surfactants, antioxidants, corrosion inhibitors and the like. Mixtures of such additional components are also contemplated by the present invention. Thus, a composition containing a combination of an antioxidant and a corrosion inhibitor as well as a composition containing two corrosion inhibitors are within the present invention. Preferably, the present compositions include a corrosion inhibitor. It is more preferred for the present compositions to include a corrosion inhibitor and an antioxidant.

The additional surfactant may be any which does not adversely affect the tin or tin-alloy stripping ability of the present composition may be used. Preferably, such additional surfactants are non-ionic.

Suitable antioxidants are any which prevent or minimize the oxidation of tin (II) into tin (IV). Suitable antioxidants include, but are not limited to hydroquinone, catechol, resorcinol, 2,5-dihydroxy benzenesulfonic acid, monopotassium salt and the like. When present, such antioxidants are typically used in an amount from 0.05 to 10 g/L, preferably from 0.1 to 8 g/L and more preferably from 0.2 to 5 g/L. A particularly suitable amount of antioxidant is from 0.5 to 2 g/L.

A wide variety of corrosion inhibitors may suitably be used in the present invention. Suitable corrosion inhibitors include, but are not limited to, catechol, tert-butylcatechol, benzoic acid, tert-butylbenzoic acid, disodium sebacate, triethanolamine laurate, isononanoic acid, triethanolamine salt of para-toluenesulfonamidocaproic acid, N-acyl α-amino acids and salts of N-acyl α-amino acids, nonylphenoxyacetic acid, polycarboxylic acids, nitrogen-containing heterocycles such as triazoles, imidazoles, imidazolines, and oxazolines, phosphorus-containing compounds such as amine phosphates, phosphonic acids, phosphonates, phosphonocarboxylic acids, and phosphinocarboxylic acids, and the like.

The preferred corrosion inhibitors are N-acyl α-amino acids and salts thereof. Typical α-amino acid salts include the sodium salt, potassium salt and ammonium salt, although other salts may suitable be used. Suitable α-amino acids include, but are not limited to, sarcosine (N-methyl glycine), alanine, leucine, valine, isoleucine, proline, tyrosine, phenylalanine, histidine, serine, and the like. Salts of N-acyl α-amino acids include the ammonium salts and alkali metal salts, such as the potassium or sodium salts. Sarcosines and sarcosinate salts are preferred. Suitable N-acyl sarcosines and salts thereof are those containing an acyl group having from 2 to 24 carbons, and preferably from 12 to 18 carbons. Exemplary N-acyl sarcosines and sarcosinate salts include, but are not limited to, N-acetylsarcosine, N-valeroylsarcosine, N-caproylsarcosine, N-octanoylsarcosine, N-lauroylsarcosine, N-tetradecanoylsarcosine, N-octadecanoylsarcosine, and their salts, particularly their sodium, potassium or ammonium salts. Preferred N-acylsarcosines are N-lauroylsarcosine, sodium N-lauroylsarcosinate, potassium N-lauroylsarcosinate, N-tetradecanoylsarcosine, sodium N-tetradecanoylsarcosinate, potassium N-tetradecanoylsarcosinate, N-octadecanoylsarcosine, sodium N-octadecanoylsarcosinate, and potassium N-octadecanoylsarcosinate.

When used, such corrosion inhibitors do not need to be present in large amounts. Any amount of corrosion inhibitor sufficient to prevent or reduce corrosion of the substrate, particularly stainless steel substrates, may be employed in the present invention. The amount of corrosion inhibitor necessary depends upon the particular corrosion inhibitor selected as well as the substrate containing the tin or tin alloy to be stripped. Thus, as little as 1 ppm may be sufficient to reduce or eliminate corrosion of the substrate having the tin or tin-alloy deposited thereon. Typically, the corrosion inhibitor may be used in an amount of 1 to 10,000 ppm or greater. Preferably, the corrosion inhibitor is at least 50 ppm and more preferably at least 75 ppm. Typically, the corrosion inhibitor is used in the present compositions in an amount from 50 to 5000 ppm, and more typically from 75 to 300ppm.

Stripping compositions of the present invention are typically prepared by combining the one or more organic sulfonic acids, one or more nitro-substituted organic compounds, sulfuric acid and any optional components in any order. It is preferred that when a corrosion inhibitor is used that it is added in the form of a solution in organic solvent as a last ingredient.

The present stripping compositions generally further include water. Any amount of water may be added to the present compositions to provide the desired concentration of components in the resulting stripping bath. The specific amount of water is within the ability of one skilled in the art.

Tin and a wide variety of tin-alloys may be advantageously removed or stripped using the present composition. Such tin-alloys include tin-lead, tin-silver, tin-copper, tin-silver-copper, tin-bismuth, tin-antimony, and the like. The amount of tin in such tin-alloys can vary over a wide range, such as from 1 to 99.9%, based on the alloy composition, the balance being one or more alloying metals. Exemplary tin-lead alloys include, but are not limited to, 90/10 and 60/40. Exemplary tin-copper alloys include, but are not limited to, 93/7 to 99.9/0.1, and preferably eutectic tin-copper. The present compositions are particularly suitable for stripping lead-free tin-alloys, such as lead-free binary tin alloys and ternary tin-alloys.

The present compositions are suitable for stripping tin and tin-alloys from a variety of substrates, such as metal, e.g. copper, surfaces of printed wiring boards, electronic device packages such as lead frames, and metal conveying equipment used in the manufacture of electronic devices such as stainless steel belts. In particular, the present compositions are suitable for the electrolytic stripping of tin and tin-alloys from a substrate, preferably a stainless steel substrate.

Thus, the present invention includes a method for electrolytic stripping of tin and tin-alloys from a substrate including the steps of: i) contacting the substrate containing tin or tin-alloy with the composition including a) one or more organic sulfonic acids; b) one or more nitro-substituted organic compounds; and c) at least one of sulfuric acid or a non-ionic surfactant having a cloud point of 50 to 80° C; and ii) applying sufficient anodic potential to the substrate to at least partially remove the tin or tin-alloy. Typically, the anodic potential is in the range of 1.2 to 2 V, and preferably 1.4 to 1.6 V. The anodic potential is applied for a period of time sufficient to at least partially remove the tin and tin-alloy and preferably for a time sufficient to remove the tin and tin-alloy.

Tin and tin-alloy solder on electronic devices such as printed wiring boards can effectively be removed according to the present invention. Thus, the present invention provides a method for manufacturing an electronic device including a step of stripping tin or tin-alloys from an electronic device, including the step of contacting an electronic device containing tin or tin-alloy with a composition including a) one or more organic sulfonic acids; b) one or more nitro-substituted organic compounds; and c) sulfuric acid; for a period of time sufficient to at least partially remove the tin or tin-alloy.

In another embodiment, the present invention provides a process for the manufacture of electronic devices including a step of stripping tin or tin-alloys from an electronic device including the steps of: i) contacting an electronic device containing tin or tin-alloy with a composition including a) one or more organic sulfonic acids; b) one or more nitro-substituted organic compounds; and c) sulfuric acid; wherein the composition is substantially free of added nitric acid and nitrate ions; and ii) a applying sufficient anodic potential to the substrate to at least partially remove the tin or tin-alloy.

A further embodiment of the present invention is a method for removing tin or tin-alloy from metal conveying equipment used in the manufacture of electronic devices including the steps of: a) contacting the metal conveying equipment containing tin or tin-alloy with a composition including: 1) one or more organic sulfonic acids; 2) one or more nitro-substituted organic compounds; and 3) at least one of sulfuric acid or a non-ionic surfactant having a cloud point of 50 to 80° C; and b) a applying sufficient anodic potential to the metal conveying equipment to at least partially remove the tin or tin-alloy. Preferred metal conveying equipment are stainless steel belts and clips used to transport lead frames throughout the manufacturing process.

In such a lead frame manufacturing processes, the stainless steel belt and clips are contacted with a tin or tin-alloy stripping bath, as described above. Prior to exiting the stripping bath, the belt and clips pass through a reverse polarity electrode system. This system plates a flash coat of tin back on the stainless steel belt and clips. Such tin flash coat improves the adhesion of an electroplated tin coating. A flash tin coating is typically required as the stainless steel would otherwise become passivated with repeated exposure to the tin plating/tin stripping cycle. Once the stainless steel becomes passivated, tin that deposits on it will flake off during the electroplating process. Such tin flaking is unwanted as the this forms particulates in the plating bath which could form shorts in the plated electronic device, cause rough deposits, and the like.

Tin and tin-alloy deposits are removed by contacting such deposits with the present compositions for a period of time sufficient to at least partially remove the tin or tin-alloy from the substrate. Preferably, the tin and tin-alloy deposits are contacted with the present compositions for a period of time sufficient to remove the tin and tin-alloy deposits from the substrate. The particular time required to remove such tin and tin-alloy deposits depends upon the particular stripping composition selected and the concentration of the components in the stripping composition, the temperature of the stripping bath and the particular tin-alloy to be removed. Suitable contact times are from 5 to 120 seconds, and preferably from 10 to 45 seconds.

Generally, the present compositions are heated. A wide range of temperatures are suitable, such as from room temperature to 65° C (150° F). Preferably, the present stripping baths are operated at a temperature in the range of 40° to 60° C, and more preferably from 45° to 55° C. The present stripping compositions offer the advantage that they work well at higher temperatures than conventional tin and tin-alloy stripping baths.

The tin and tin-alloy deposits can be contacted with the present compositions in a variety of ways, such as by immersing or dipping the tin and tin-alloys in the stripping compositions, or by spraying the stripping compositions on the tin and tin-alloy. Other methods are well within the ability of one skilled in the art.

Precipitate is typically formed over time in a tin or tin-alloy stripping bath as the bath is used. Such precipitate is typically removed by filtration, thus allowing continued use of the stripping bath. However, such precipitate is not always easily filterable, thus leading to clogged filters and/or disposal of the entire stripping bath. The present stripping compositions have the advantage that such precipitate is more easily filterable as compared to conventional tin and tin-alloy stripping baths. Thus, the present stripping baths can be used for longer periods of time, thus reducing the amount of waste to be disposed of and saving time and money for the manufacturer.

Also provided by the present invention is an apparatus for manufacturing electronic devices including a tin or tin-alloy stripping apparatus comprising a tank containing a composition including a) one or more organic sulfonic acids; b) one or more nitro-substituted organic compounds; and c) at least one of sulfuric acid or a non-ionic surfactant having a cloud point of 50 to 80° C; a cathode and a means for applying an anodic potential to a substrate containing tin or tin-alloy. An exemplary apparatus is that used in the manufacture of lead frames where the stainless steel belt is the substrate. The apparatus also contains a cathode, usually made of stainless steel, which is immersed into the same solution as a belt. Potential may be applied by direct current, pulse current, pulse-periodic-reverse and superimposed alternating current. For example, when direct current is used, the potential is applied by connecting both electrodes to the output of a direct current rectifier by means of conductive leads.

Another advantage of the present stripping compositions is that they remove tin and tin-alloys faster than conventional stripping compositions, particularly when electrolytic stripping is employed. Such increased stripping rates reduce the time required for removing tin and tin-alloy deposits, thus increasing manufacturing throughput.

A further advantage of the present compositions is that they are very effective at stripping tin and tin-alloys without using added thiourea, thiourea derivatives, inorganic compounds that liberate halogen atoms or halogen-containing complexes in acidic solution, or a haloacetic acid. Thus, it is preferred that the present compositions are free of added thiourea, thiourea derivatives, inorganic compounds that liberate halogen atoms or halogen-containing complexes in acidic solution, or a haloacetic acid.

The following examples are intended to illustrate further various aspects of the present invention, but are not intended to limit the scope of the invention in any aspect.

### Example 1

A stripping composition was prepared by combining the components and in the amounts shown below:

| Component | Amount |
|---|---|
| Nitrobenzenesulfonic acid | 25 g/L |
| Methanesulfonic acid | 350 mL/L |
| Ethylene oxide/propylene oxide block copolymer | 0.25 g/L |
| 2,5-dihydroxy benzenesulfonic acid, monopotassium salt | 0.5 g/L |
| N-laurylsarcosinate, sodium salt | 150 ppm |
| Sulfuric acid | 3.3 mL/L |
| Water | Required volume |

### Example 2 (Comparative)

A conventional stripping composition was prepared by combining the components and in the amounts shown below.

| Component | Amount |
|---|---|
| Nitrobenzenesulfonic acid | 5 g/L |
| Methanesulfonic acid | 350 mL/L |
| Ethoxylated/propoxylated butanol | 0.01 g/L |
| Hydroquinone | 0.5 g/L |
| Water | Required volume |

### Example 3

Tin or tin-alloys were plated on 3 x 4 inch (ca. 7.6 x 10.2 cm) stainless steel Hull cell panels. Commercially available plating baths and standard plating conditions were used to deposit the tin and tin-alloys.

A panel plated with tin and each alloy was then contacted with the stripping compositions of either Example 1 or Example 2. The stripping compositions were maintained at a temperature of 50° C. An anodic potential of 1.5 V was applied to the panels and continued until the current became negligible, indicating passivation of the stainless steel and complete removal of the deposit. The stripping rates were measured (in µin/min) and the results are reported in Table 1.

**Table 1**

| Deposit | Stripping Rate of Bath of Example 1 (µin/min) | Stripping Rate of Bath of Example 2 (Comparative) (µin/min) |
|---|---|---|
| Tin-Lead | 1122 | 875 |
| Tin-Bismuth | 1078 | 817 |
| Tin-Copper | 716 | 644 |
| Pure Tin | 988 | 806 |

The above data clearly show that the compositions of the present invention have increased stripping rates as compared to conventional tin and tin-alloy stripping baths.

### Example 4

The procedure of Example 1 was repeated except that the corrosion inhibitor, sodium N-laurylsarcosinate, was omitted.

### Example 5

Stainless steel belt material (SS316) containing stainless steel clips (SS302) was plated with pure tin using a conventional tin plating bath under standard plating conditions and then the tin was removed from the belt material using the stripping compositions of Examples 1 and 4 at 35° C. The corrosivity of the stripping baths to the stainless steel was evaluated by repeated plating and stripping of the belt material.

In each stripping cycle, an anodic potential of 1.5 V was applied to the belt material and continued until the current became negligible, indicating complete removal of the tin. When the current became negligible, the stripping cycle was considered completed. The stainless steel belt material was then re-plated with tin and the stripping cycle repeated. This plating/stripping cycle was repeated 50 times to mimic a conventional lead frame manufacturing process having a continuous stainless steel belt.

The stripping compositions were analyzed for stainless steel alloying metal content using an inductively coupled plasma ("ICP") technique prior to the first stripping cycle and after every 10 cycles. The presence of stainless steel alloying metals in the stripping baths indicates corrosion of the stainless steel. The lower the amounts of such alloying metals, the less corrosion of the stainless steel. The results are reported in Table 2.

**Table 2**

| Bath of Example 1 (with corrosion inhibitor) | | | |
|---|---|---|---|
| Cycles | Chromium (ppm) | Iron (ppm) | Nickel (ppm) |
| 0 | 0.0 | 0.4 | 0.0 |
| 10 | 1.2 | 4.9 | 0.9 |
| 20 | 1.8 | 7.1 | 1.3 |
| 30 | 2.3 | 9.3 | 1.8 |
| 40 | 3.1 | 11.8 | 2.4 |
| 50 | 3.6 | 15.0 | 2.9 |
| | | | |

| Bath of Example 4 (without corrosion inhibitor) | | | |
|---|---|---|---|
| Cycles | Chromium (ppm) | Iron (ppm) | Nickel (ppm) |
| 0 | 0.0 | 1.5 | 0.0 |
| 10 | 8.3 | 29.7 | 4.5 |
| 20 | 16.1 | 55.4 | 8.5 |
| 30 | 23.1 | 77.9 | 12.4 |
| 40 | 30.0 | 99.9 | 15.7 |
| 50 | 34.7 | 115.3 | 18.0 |

The above data clearly show that the small amount of corrosion inhibitor in the bath of Example 1 is extremely effective in reducing the corrosion of stainless steel. Thus, the present stripping compositions provide faster removal of tin and tin-alloy deposits, can be used at higher temperatures, and show reduced corrosion of stainless steel .

### Example 6

The procedure of Example 1 is repeated except that the sodium N-laurylsarcosinate is used in an amount of 100 ppm.

### Example 7

The Procedure of Example 1 is repeated except that sodium N-laurylsarcosinate is replaced with tert-butylcatechol and the ethylene oxide/propylene oxide block copolymer is replaced with β-naphthol condensed with 13 moles of ethylene oxide.

### Example 8

The procedure of Example 6 is repeated except that the sodium N-laurylsarcosinate is replaced with triethanolamine laurate.

### Example 9

The procedure of Example 7 is repeated except that the tert-butylcatechol is used in an amount of 200 ppm and the β-naphthol condensed with 13 moles of ethylene oxide is replaced with butanol condensed with 10 moles of ethylene oxide.

### Example 10

The procedure of Example 9 is repeated except that the tert-butylcatechol is replaced with triazole and the butanol condensed with 10 moles of ethylene oxide is replaced with styrenated phenol condensed with 5 moles of ethylene oxide.

### Example 11

The procedure of Example 1 is repeated except that the sodium N-laurylsarcosinate is replaced with N-octanoylsarcosine in an amount of 225 ppm.

### Example 12

The procedure of Example 1 is repeated except that the sodium N-laurylsarcosinate is replaced with N-tetradecanoylsarcosine in an amount of 275 ppm.

### Example 13

The procedure of Example 1 is repeated except that the sodium N-laurylsarcosinate is replaced with N-octadecanoylsarcosinate, potassium salt in an amount of 100 ppm.

## Claims

1. A composition suitable for stripping of tin and tin-alloys from a substrate comprising:
a) one or more organic sulfonic acids;
b) one or more nitro-substituted organic compounds; and
c) at least one of sulfuric acid or a non-ionic surfactant having a cloud point of 50 to 80°C.

2. The composition of claim 1 wherein the one or more organic sulfonic acids are selected from methanesulfonic acid, ethanesulfonic acid, propanesulfonic acid, phenylsulfonic acid, tolylsulfonic acid, or halobenzenesulfonic acid.

3. The composition of any of the preceding claims wherein the one or more nitro-substituted organic compounds further comprise one or more water-solubility enhancing substituents selected from -SO₃H and -CO₂H.

4. The composition of any of the preceding claims wherein the one or more nitro-substituted organic compounds are selected from nitrobenzenesulfonic acid, alkali and alkaline earth salts of nitrobenzenesulfonic acid, nitrobenzenecarboxylic acid, alkali and alkaline earth salts of nitrobenzenecarboxylic acid, nitrohalobenzenes, nitroanilines or nitrophenols.

5. The composition of any of the preceding claims wherein the one or more alkanesulfonic acids are present in an amount of from 10 to 500 mL/L, the one or more nitro-substituted organic compounds are present in an amount of 5 to 50 g/L, and the at least one non-ionic surfactant is present in an amount of 0.05 to 2 g/L.

6. The composition of any of the preceding claims further comprising one or more corrosion inhibitors selected from catechol, tert-butylcatechol, benzoic acid, tert-butylbenzoic acid, disodium sebacate, triethanolamine laurate, isononanoic acid, triethanolamine salt of para-toluenesulfonamidocaproic acid, N-acyl α-amino acids, N-acyl α-amino acid salts, nonylphenoxyacetic acid, polycarboxylic acids, nitrogen-containing heterocycles, or phosphorus-containing compounds.

7. The composition of any of claims 1-4 and 6 wherein the composition is free of sulfuric acid and the one or more nitro-substituted organic compounds are present in an amount of 5 g/L or more.

8. A method for electrolytic stripping of tin and tin-alloys from a substrate comprising the steps of:
a) contacting a substrate containing tin or tin-alloy with the composition of any of the preceding claims; and
b) applying sufficient anodic potential to the substrate to at least partially remove the tin or tin-alloy.

9. The method of claim 8, wherein the substrate is an electronic device substrate.

10. A method for removing tin or tin-alloy from metal conveying equipment used in the manufacture of electronic devices comprising the steps of:
a) contacting the metal conveying equipment containing tin or tin-alloy with the composition of any of claims 1-7; and
b) applying sufficient anodic potential to the metal conveying equipment to at least partially remove the tin or tin-alloy.
